# EUROPEAN PATENT APPLICATION

(11) **EP 2 043 164 A2**
(43) Date of publication of application: **01.04.2009**
(21) Application number: 08253118.7
(22) Date of filing: 24.09.2008
(51) Int. Cl.: H01L 31/05, H01L 31/048

(54) **Solar cell module**

(30) Priority: 25.09.2007 JP 2007248040
(71) Applicant: Sanyo Electric Co., Ltd., Osaka 570-8677 (JP)
(72) Inventor: Shima, Masaki , Sanyo Electric Co., Ltd., Osaka 570-8677 (JP); Ienaga, Teruhiko , Sanyo Electric Co., Ltd., Osaka 570-8677 (JP); Kannou, Hiroyuki , Sanyo Electric Co., Ltd., Osaka 570-8677 (JP)
(74) Representative: Calderbank, Thomas Roger

(57) **Abstract**

According to a solar cell module 100 of the present invention, a wiring member (first wiring member 11, second wiring member 12m or fourth wiring member 14) includes contact portions 11a, 12a, and 14a which contacts with the main surface of the solar cell 10, and noncontact portions 11b, 12b, and 14b continuous with the contact portions 11a, 12a, and 14a and extending outward from the main surface of the solar cell 10. The noncontact portion is arranged to leave a space from a boundary portion α between the main surface of the solar cell 10 and the side surface of the solar cell 10.

## Description

This application is based upon and claims the benefit of priority from the prior Japanese Patent Application No. P 2007-248040, filed on September 25, 2007; the entire contents of which are incorporated herein by reference.

The present invention relates to a solar cell module including solar cells connected by wiring members.

Solar cells are expected as a new energy source that can directly convert clean and inexhaustibly supplied sunlight into electricity.

In general, each solar cell can output an energy of several watts. Accordingly, as a power source for a house, a building or the like, it is common to use a solar cell module that includes a plurality of solar cells connected to one another in order to provide enhanced energy output.

A solar cell module includes a plurality of solar cell strings formed by arranging a predetermined number of solar cells along arrangement directions. The power-generating region of the solar cell module is formed by electrically connecting the plurality of solar cell strings.

The predetermined number of solar cells included in the solar cell string are electrically connected to each other by a first wiring member. The plurality of solar cell strings are electrically connected to each other by a second wiring member provided on solar cells located at both end portions of the plurality of solar cell strings. Third wiring member, for extracting the power from the power-generating region, are arranged on solar cells located at electrical endpoints of the power-generating region. In this way, various wiring members are provided on each of the solar cells depending on the purpose for using the wiring members. (for example, see Japanese Patent Application Publication No. 2006-278904).

Such wiring members are electrically connected to main surfaces of respective solar cells. Here, in order to make the manufacturing process easier, each of the wiring members are linearly-extended outward from the main surface of the respective solar cells, Accordingly, each of the contact portions of the respective wiring members, the contact portions being in contact with the main surface of the respective solar cells, also contacts with each of the boundary portions between the main surfaces and side surfaces of the respective solar cells.

In the process of manufacturing the solar cell module, a pressure is applied to each of the solar cells connected to the wiring members. Specifically, a laminated body in which a first protecting member, a first sealing member, the plurality of solar cells, a second sealing member, and a second protecting member, is pressed from above and below while being heated.

Here, on the main surface of each of the solar cells, larger pressure tends to be applied to the area in contact with the wiring member, compared to the area not in contact with the wiring member. Moreover, the boundary portions of the solar cells are easily damaged by an external force.

As described above, the contact portions of the respective wiring members are in contact with the boundary portions of each of the solar cells. For this reason, when the pressure is applied to each of the solar cells, damage, such as chipping and cracking or the like, may be generated at the contact point between the contact portion and the boundary portion of each of the solar cells, thereby causing the damage to this boundary portion. This causes a problem of reducing the manufacturing yield of the solar cell module.

An aspect of the present invention is summarized as a solar cell module including: a plurality of solar cells each having a first main surface, a second main surface provided on an opposite side of the first main surface, and a side surface continuous with the first main surface and the second main surface; a first-main-surface-side protecting member provided on a first main surface side of each of the plurality of solar cells; a second-main-surface-side protecting member provided on a second main surface side of each of the plurality of solar cells; a sealing member sealing the plurality of solar cells between the first-main-surface-side protecting member and the second-main-surface-side protecting member; and a wiring member electrically connected to the plurality of solar cells.

In this solar cell module, the wiring member includes: a first contact portion which contacts with the first main surface of a first solar cell included in the plurality of solar cells; and a first noncontact portion continuous with the first contact portion and extending outward from the first main surface of the first solar cell. The first noncontact portion is arranged to leave a space from a boundary between the first main surface of the first solar cell and the side surface of the first solar cell.

According to this solar cell module, the wiring members connected to the first solar cell are not in contact with the boundary portions between the main surface and the side surface of the first solar cell. As a result, in the process of manufacturing the solar cell module, the boundary portion can be prevented from receiving pressure directly from the wiring members. Therefore, the boundary portion of each of the plurality of solar cells can be prevented from being chipped or cracked.

In the above aspect of the present invention, it is preferable that the first noncontact portion extends away from the first main surface towards the first-main-surface-side protecting member at a boundary between the first main surface and the side surface of the first solar cell.

In the above apect of the present invention, it is preferable that the plurality of solar cells includes a second solar cell, which is adjacent to the first solar cell, and the first solar cell and the second solar cell are connected to each other by the wiring member. It is preferable that the wiring member includes:a second contact portion continuous with the first noncontact portion and contacts with the second main surface of the second solar cell.

Further, in the above apect of the present invention, it is preferable that the plurality of solar cells includes a second solar cell, which is adjacent to the first solar cell, and the first solar cell and the second solar cell are connected to each other by the wiring member. It is preferable that the wiring member includes:a second contact portion which contacts with the second main surface of the second solar cell; and a second noncontact portion continuous with the second contact portion and extending outward from the second main surface of the second solar cell, and the second noncontact portion is arranged to leave a space from a boundary between the first main surface of the second solar cell and the side surface of the second solar cell.

Moreover, in the above aspect of the present invention, it is preferable that the second noncontact portion extends away from the second main surface towards the second-main-surface-side protecting member at a boundary between the seconed main surface and the side surface of the second solar cell.

Further, in the aspect of the present invention, it is preferable that the first and second noncontact portions are continuous smoothly with the first contact portion.

Moreover, in the aspect of the present invention, it is preferable that the first-main-surface-side protecting member is formed of a glass or an acrylic resin.

IN THE DRAWINGS:
Fig. 1 is a plan view of a solar cell module 100 according to an embodiment of the present invention.
Fig. 2 is a side view of the solar cell module 100 according to the embodiment of the present invention.
Fig. 3 is an enlarged side view of a part of a plurality of solar cells 10 according to the embodiment of the present invention.
Fig. 4 is an enlarged side view of a part of the plurality of solar cells 10 according to the embodiment of the present invention.
Fig. 5 is an enlarged side view of a part of the plurality of solar cells 10 according to the embodiment of the present invention.

Next, an embodiment of the present invention will be described by using the accompanying drawings. Throughout the drawings, identical or similar components are denoted by identical or similar reference numerals. It is to be noted, however, that the drawings are schematic, and that the dimensional proportions and others are different from their actual values. Accordingly, specific dimensions and others should be inferred based on the description given below. Moreover, as a matter of course, dimensional relationships and dimensional proportions may be different from one drawing to another in some parts.

### (Overall Configuration of Solar Cell Module)

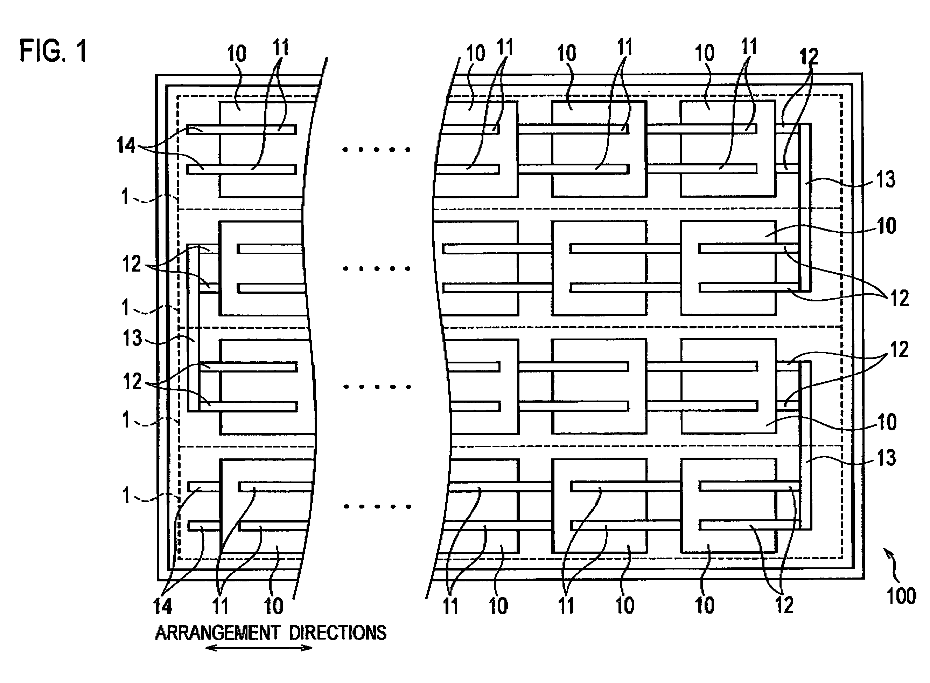

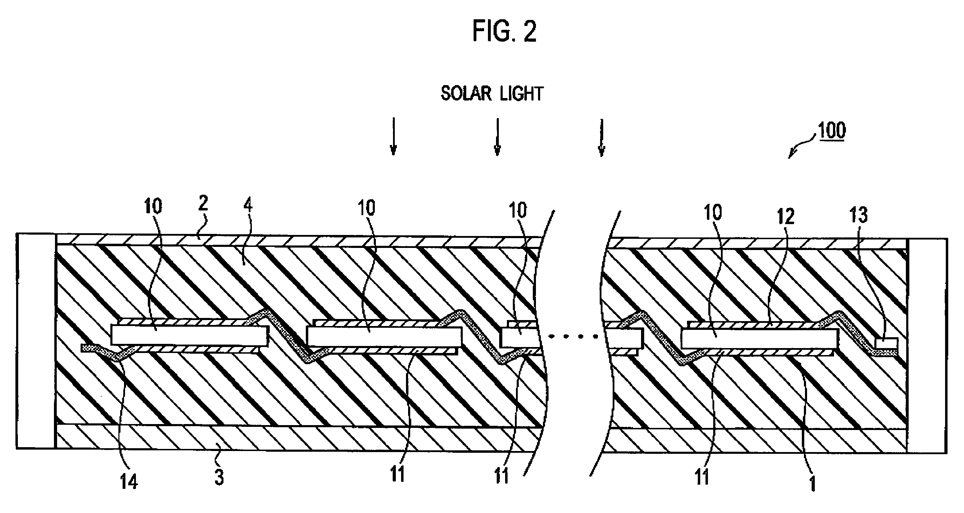

With reference to Figs. 1 and 2, description will be given of an overall configuration of a solar cell module 100 according to the embodiment of the present invention. Fig. 1 is a plan view showing a light-receiving side of the solar cell module 100 according to the present embodiment. Fig. 2 is a side view of the solar cell module 100 according to the present embodiment.

As illustrated in Fig. 1, the solar cell module 100 includes a plurality of solar cell strings 1, first wiring member 11, second wiring member 12, third wiring member 13, and fourth wiring member 14.

Each of the plurality of solar cell strings 1 includes a plurality of solar cells 10 located in arrangement directions. The plurality of solar cells 10 is electrically connected to one another by the first wiring member 11. The plurality of solar cell strings 1 is located orthogonal to the arrangement directions.

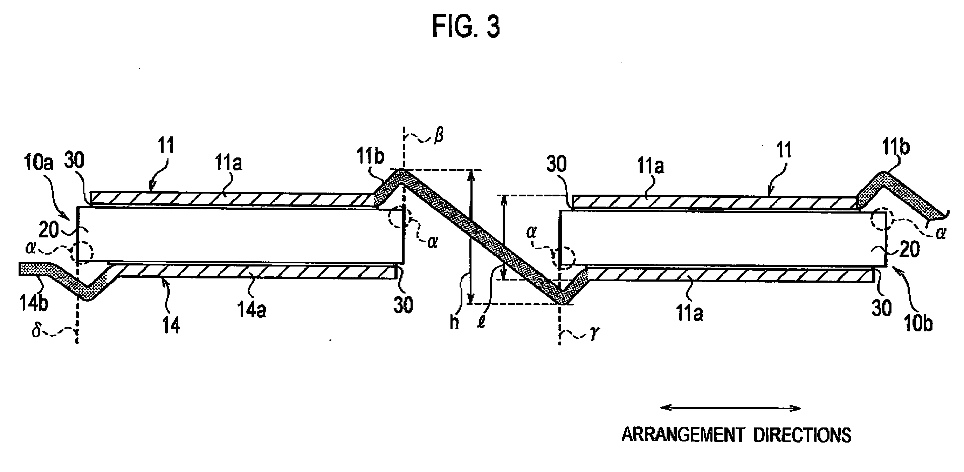

Each of the plurality of solar cells 10 includes: a light-receiving surface on which solar light enters, a back surface provided on the opposite side of the light-receiving surface, side surfaces continuous with the light-receiving surface and the back surface, and a photoelectric conversion part 20 (not shown in Figs. 1 and 2; but shown in Fig. 3). The light-receiving surface and the back surface of each of the plurality of solar cells 10 are referred to as main surfaces of each of the solar cells 10, respectively. Each of the plurality of solar cells 10 includes collecting electrodes 30 formed on the light-receiving surface and the back surface, respectively (see Fig. 3). The photoelectric conversion part 20 generates photo-generated carriers by receiving the solar light on the light-receiving surface. The collecting electrode 30 then collects the photo-generated carriers thus generated by the photoelectric conversion part 20.

The first wiring member 11 electrically connects the collecting electrode 30 formed on the light-receiving surface of one of the plurality of solar cells 10 and the collecting electrode 30 formed on the back surface of another one of the plurality of the solar cells 10. Here, the another one of the plurality of the solar cells 10 is adjacent to the one of the plurality of the solar cells 10. One end portion of the first wiring member 11 is in contact with the light-receiving surface of the one of the plurality of solar cells 10. The other end portion of the first wiring member 11 is in contact with the back surface of the another one of the plurality of solar cells 10. Thereby, the one of the plurality of solar cells 10 is electrically connected to the another one of the plurality of solar cells 10 in series.

As the first wiring member 11, a conductive material such as copper, which is formed either into a thin-plate shape or into a twisted-wire shape, may be used. Here, on a surface of thin-film copper or the like used as first wiring member 11, a soft conductive material such as eutectic solder may be plated.

Note that although two first wiring members 11 are provided on each of the main surfaces of each of the plurality of solar cells 10 in the present embodiment, the number of the first wiring member is not limited to this. The number and size of the first wiring member 11 may be suitably modified in consideration of the size and the output of each of the plurality of solar cells 10. In addition, although the each of the plurality of solar cells 10 is electrically connected to one another in series in the present embodiment, the each of the plurality of solar cells 10 may also be electrically connected to one another in parallel.

The second wiring members 12 are electrically connected to the collecting electrodes 30 formed on the respective main surface of a solar cell, which is included in the plurality of solar cells 10, located at each ends of the one of the plurality of solar cell strings 1. Each of the second wiring members 12 is located in the arrangement directions. One end portion of the second wiring member 12 is in contact with the light receiving surface or the back surface of the solar cell located at this end. The other end portion of the second wiring member 12 extends outward from the main surface of each of the solar cell located at this end. The second wiring member 12 may be formed of the same material as the first wiring member 11. The number and size of the second wiring member 12 may be suitably modified in consideration of the size and the output of the plurality of solar cells 10.

The third wiring member 13 electrically connects the plurality of solar cell strings 1 to another, which are adjacent to each other. One end portion of the third wiring member 13 is connected to two of the second wiring members 12 connected to the solar cell located at one end of the one of the plurality of solar cell string 1. The other end portion of the third wiring member 13 is connected to different two of the second wiring members 12 connected to the solar cell located at the end of the another one of the plurality of solar cell strings 1. In other words, the one of the plurality of solar cell strings 1 and another one of the plurality of the solar cell strings 1 are electrically connected to one another in series by the third wiring member 13. Thereby, the power-generating region of the solar cell module 100 is formed. The third wiring member 13 is located orthogonal to the arrangement directions. The third wiring member 13 may be formed of the same material as the first wiring member 11. In addition, although the each of the solar cell strings 1 is electrically connected to one another in series in the present embodiment, the plurality of solar cell strings 1 may also be electrically connected to one another in parallel.

The fourth wiring member 14 leads the power generated by the power-generating region of the solar cell module 100 to the outside. The fourth wiring member 14 is connected to a solar cell, which is included in the plurality of the solar cell 10, located at the electrical endpoint of the power-generating region. One end portion of the fourth wiring member 14 is connected to one of the main surfaces of the solar cell located at the electrical endpoint of the power-generating region. The other end portion of the fourth wiring member 14 extends outward from the main surface of the solar cell located at the electrical endpoint of the power-generating region, and is stored in a terminal box (not shown). The fourth wiring member 14 may be formed of the same material as the first wiring member 11.

As illustrated in Fig. 2, the solar module 100 includes a light-receiving-surface-side protecting member 2, a back-surface-side protecting member 3, and a sealing member 4. The solar module 100 is configured by including the sealing member 4 which seals the plurality of solar cell strings 1 between the light-receiving-surface-side protecting member 2 and the back-surface-side protecting member 3.

The light-receiving-surface-side protecting member 2 is provided on the light-receiving surface side of the sealing member 4, and protects the light-receiving surface of the solar cell module 100. As the light-receiving-surface-side protecting member 2, materials such a glass plate, an acrylic resin plate, and a translucent plastic plate, may be used. The light-receiving-surface-side protecting member 2 according to the present embodiment is formed of a glass plate.

The back-surface-side protective member 3 is provided on the back surface of the sealing member 4, and protects the back surface of the solar cell module 10. As the back-surface-side protective member 3, a resin film such as a PET (polyethylene terephthalate) film or a laminated film having a structure in which an Al foil is sandwiched therebetween, may be used. The back-surface-side protecting member 3 according to the present embodiment is formed of an acrylic resin plate.

The sealing member 4 seals the plurality of solar cell strings 1 between the light-receiving-surface-side protective member 2 and the back-surface-side protective member 3. Examples of a material usable as the sealing member 4 include translucent resins such as an EVA, EEA, PVB, silicon, urethane, acryl, and epoxy, and a sealing structure body having an insulating film, such as a PET, interposed between the above-mentioned resins.

It should be noted that an Al frame (not shown) may be attached to an outer periphery of the solar cell module 100 having the above-described configuration.

### (Detailed Configuration of Wiring members)

Next, referring to Fig. 3, description will be given of detailed configurations of the first wiring member 11 and the fourth wiring member 14. Fig. 3 is an enlarged side view of two solar cells, which is included in the plurality of solar cells 10, located at one of the end portion of one of the plurality of solar cell strings 1 (hereinafter, these two solar cells 10 are referred to as a solar cell 10a and a solar cell 10b, respectively).

The first wiring member 11 is electrically connected to the light-receiving surface of the solar cell 10a and to the back surface of the solar cell 10b. Accordingly, the first wiring member 11 has a contact portion 11a in contact with the main surfaces of the solar cell 10a and the solar cell 10b, respectively. The first wiring member 11 also has a noncontact portion 11b continuous with the contact portion 11a and extending outward from the main surfaces of the solar cell 10a and the solar cell 10b. As illustrated in Fig. 3, the noncontact portion 11b is located between the solar cell 10a and the solar cell 10b. Note that the noncontact portion 11b is formed integrally with the contact portion 11a in the present embodiment.

The contact portion 11a is connected to the collecting electrode 30 formed on the photoelectric conversion part 20 of the solar cell 10a and the solar cell 10b, respectively. Thereby, the first wiring member 11 is electrically connected to the solar cell 10a and to the solar cell 10b.

The noncontact portion 11b is arranged to leave a space from a boundary portion α. Here, the boundary portion α indicates a portion between the main surface and the side surface of the respective solar cells 10a and 10b. To be more specific, the noncontact portion 11b curves from one end of the contact portion 11a connected to the light-receiving surface of the solar cell 10a, and extends away from the light-receiving surface. Then, the noncontact portion 11b bends toward the back surface of the solar cell 10b before the wiring member 11 reaches a reference line β. Here, the reference line β indicates an end of the light-receiving surface of the solar cell 10a.

Accordingly, the noncontact portion 11b extends away from the light-receiving surface of the solar cell 10a towards the light-receiving-surface-side protective member 2, at a boundary between the main surface and the side surface of the solar cell 10a.

Similarly, the noncontact portion 11b curves from one end of the contact portion 11a connected to the back surface of the solar cell 10b, and extends away from the back surface. Then, the noncontact portion 11b bends toward the light-receiving surface of the solar cell 10a before the wiring member 11 reaches a reference line γ indicating an end of the back surface of the solar cell 10b.

Accordingly, the noncontact portion 11b extends away from the back surface of the solar cell 10b towards the back-surface-side protective member 3, at a boundary between the back surface and the side surface of the solar cell 10b.

Here, a symbol h shown in Fig. 3 indicates a distance between a point to which the noncontact portion 11b bends toward the back surface of the solar cell 10b and a point to which the noncontact portion 11b bends toward the light-receiving surface of the solar cell 10a. The distance h is larger than a distance / indicating a distance in orthogonal direction between the contact portion 11a located on the light-receiving surface of the solar cell 10a and the contact portion 11a located on the back surface of the solar cell 10b.

The fourth wiring member 14 is electrically connected to the back surface of the solar cell 10a. The fourth wiring member 14 has a contact portion 14a in contact with the back surface of the solar cell 10a, and a noncontact portion 14b continuous with the contact portion 14a and extending outward from the back surface of the solar cell 10a.

The contact portion 14a is connected to the collecting electrode 30 formed on the photoelectric conversion part 20 of the solar cell 10a. Thereby, the fourth wiring member 14 is electrically connected to the solar cell 10a.

The noncontact portion 14b is arranged to leave a space from the boundary portion α between the main surface and the side surface of the solar cell 10a. To be more specific, the noncontact portion 14b curves from one end of the contact portion 14a connected to the back surface of the solar cell 10a, and extends away from the back surface. Then, the noncontact portion 14b bends toward the light-receiving surface before the wiring member 11 reaches a reference line δ indicating an end of the back surface of the solar cell 10a.

Accordingly, the noncontact portion 14b extends away from the back surface of the solar cell 10a towards the back-surface-side protective member 3, at a boundary between the back surface and the side surface of the solar cell 10a.

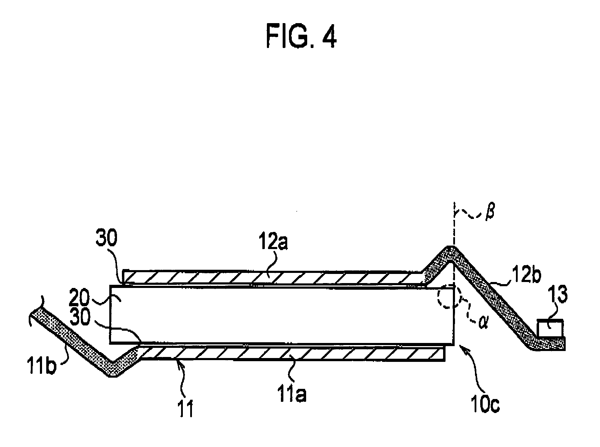

Next, referring to Fig. 4, description will be given of a detailed configuration of the second wiring member 12. Fig. 4 is a side view of one solar cell included in the plurality of solar cells 10. The one solar cell is connected to the second wiring member 12. (hereinafter, this one solar cell is referred to as a solar cell 10c).

The second wiring member 12 is electrically connected to the light-receiving surface of the solar cell 10c. The second wiring member 12 has a contact portion 12a in contact with the light-receiving surface of the solar cell 10c, and a noncontact portion 12b continuous with the contact portion 12a and extending outward from the light-receiving surface of the solar cell 10c.

The contact portion 12a is connected to the collecting electrode 30 formed on the photoelectric conversion part 20 of the solar cell 10c. Thereby, the second wiring member 12 is electrically connected to the solar cell 10c.

The noncontact portion 12b is arranged to leave a space from the boundary portion α between the main surface and the side surface of the solar cell 10c. To be more specific, the noncontact portion 12b curves from one end of the contact portion 12a connected to the light-receiving surface of the solar cell 10c, and extends away from the light-receiving surface. Then, the noncontact portion 12b bends toward the back surface side before the wiring member 11 reaches the reference line β indicating an end of the light-receiving surface of the solar cell 10c. Accordingly, the noncontact portion 12b extends away from the back surface of the solar cell 10c towards the back-side protective member 3, at a boundary between the back surface and the side surface of the solar cell 10c.

Further, the third wiring member 13 is connected to one end portion of the noncontact portion 12b.

### (Method for Manufacturing Solar Cell Module)

Next, a method for manufacturing the solar cell module 100 will be described.

Firstly, each of the plurality of solar cell strings 1 is formed by electrically connecting the plurality of solar cells 10 to one another by using the first wiring member 11. Here, the first wiring member 11 is arranged to leave a space from the boundary portions α between the main surface and the side surface of each of the plurality of solar cells 10.

Then, the second wiring member 12 or the fourth wiring member 14 is connected to solar cells, which is included in the plurality of solar cells 10, located at the ends of each of the plurality of solar cell strings 1 in the arrangement directions. Here, the second wiring member 12 or the fourth wiring member 14 is arranged to leave a space from the boundary portion α between the main surface and the side surface of the solar cells located at the ends of each of the plurality of solar cell strings 1.

Next, the plurality of solar cell strings 1 is electrically connected to one another by using the third wiring member 13.

Thereafter, a laminate body is manufactured by laminating an EVA sheet (the sealing member 4), the plurality of solar cell strings 1, an EVA sheet (the sealing member 4), and an acrylic resin plate (back-surface-side protecting member 3), on a glass plate (the light-receiving-surface-side protecting member 2).

The laminate body thus manufactured is then pressed in a vacuum atmosphere while being heated under a predetermined condition. Thereby, the plurality of solar cell strings 1 is sealed in the EVA.

It should be noted that an Al frame (not shown) may be attached to an outer periphery of the solar cell module 100 having the above-described configuration.

### (Operations and Effects)

In the solar cell module 100 according to the present embodiment, the first wiring member 11 electrically connected to each of the plurality of solar cells 10 includes: the contact portion 11a in contact with the main surface of each of the plurality of solar cells 10, and the noncontact portion 11b continuous with the contact portion 11a and extending outward from the main surface of the plurality of solar cells 10. The noncontact portion 11b is arranged to leave a space from the boundary portion α between the main surface and the side surface of each of the plurality of solar cells 10.

Further, the second wiring member 12 electrically connected to each of the plurality of solar cells 10 includes the contact portion 12a in contact with the main surface of the each of the plurality of solar cells 10, and the noncontact portion 12b continuous with the contact portion 12a and extending outward from the main surface of each of the plurality of solar cells 10. The noncontact portion 12b is arranged to leave a space from the boundary portion α between the main surface and the side surface of the plurality of solar cells 10.

Furthermore, the fourth wiring member 14 electrically connected to each of the plurality of solar cells 10 includes the contact portion 14a in contact with the main surface of the plurality of solar cells 10, and the noncontact portion 14b continuous with the contact portion 14a and extending outward from the main surface of each of the plurality of solar cells 10. The noncontact portion 14b is arranged to leave a space from the boundary portion α between the main surface and the side surface of each of the plurality of solar cells 10.

In this way, the wiring members (the first wiring member 11, the second wiring member 12, and the fourth wiring member 14) are not in contact with the boundary portions α between the main surface and the side surface of the plurality of solar cells 10. As a result, in the process of manufacturing the solar cell module 100, the boundary portion α can be prevented from receiving pressure directly from the wiring members.

Specifically, in the process of manufacturing the solar cell module 100, the laminate body is manufactured by sequentially laminating the glass plate, the EVA sheet, the plurality of solar cell strings 1, the EVA sheet, and the acrylic resin plate. When the laminate body thus manufactured is heated, the EVA melts and enters into a space between the wiring member and the boundary portion α. When the laminate body in such a state is pressed, the boundary portion α and the wiring member are not brought into contact with each other. In this way, the EVA entered into the space between the wiring member and the boundary α functions as a cushioning member.

According to the above-described solar cell module 100, the boundary portion α of each of the plurality of solar cells 10 can be prevented from being chipped or cracked.

Furthermore, in the solar cell module 100 according to the present embodiment, the respective noncontact portions (the noncontact portions 11b, 12b, and 14b) of the wiring members (the first wiring member 11, the second wiring member 12, and the fourth wiring member 14) are continuous with the corresponding contact portions (the contact portions 11a, 12a, and 14a) and do not bend at the borders therebetween. In other words, the noncontact portions extend away from the main surfaces while curving gently from the contact portions.

As described above, the borders between the noncontact portions and the contact portions do not bend. This makes it possible to avoid a concentration of a pressure applied at a portion of the main surface of each of the plurality of the solar cells 10, in the process of manufacturing the solar cell module 100.

Moreover, in the present embodiment, the light-receiving-surface-side protecting member 2 is formed of a glass, and the back-surface-side protecting member 3 is formed of an acrylic resin plate. Accordingly, the light-receiving-surface-side protecting member 2 can prevent damage to the boundary portion, which would occur by contacting with the noncontact portion.

### EXAMPLES

Hereinbelow, specific description will be given of the configuration of the solar cell module according to the present invention. However, the present invention is not to be limited to the example described below, and can be implemented by being modified as long as the gist of the present invention is not changed.

### (Examples)

A solar cell module according to the example was manufactured in the following way.

Firstly, a plurality of solar cells was prepared. Each of the solar cells had a light-receiving surface, a back surface provided on the opposite side of the light-receiving surface, and side surfaces continuous with the light-receiving surface and the back surface. Each side surface and the light-receiving surface were continuous with each other while making a right angle. Similarly, each side surface and the back surface were continuous with each other while making a right angle.

Next, a solar cell string was formed by electrically connecting a predetermined number of solar cells to one another by using wiring members for connection (the first wiring member 11). Specifically, the wiring member for connection (the first wiring member 11) each having a predetermined shape were connected to the light-receiving surface of one solar cell and to the back surface of another solar cell adjacent to the one solar cell. Further, wiring members, for connecting the plurality of the solar cells (the second wiring member 12), each having a predetermined shape were connected to the solar cells located at the ends of the solar cell strings. Further, wiring members, for extracting the power (the fourth wiring member 14), were connected to the solar cells located at electrical endpoints. Here, the predetermined shape is referred to a curved shape that each wiring member would not be in contact with a boundary between the light-receiving surface or the back surface and the side surface (hereinafter, the boundary portion will be referred to as an edge portion).

Thereafter, other wiring member is connected to the first wiring member 11, thereby connecting the plurality of solar cell strings to each other.

Then, a laminate body was manufactured by sequentially laminating a glass plate, an EVA sheet, the plurality of solar cell strings, an EVA sheet, and an acrylic resin plate.

Subsequently, the laminate body was pressed from above and below while being heated. Thereby, the EVA was completely hardened.

### (Comparative Example)

A solar cell module according to a comparative example was manufactured through a manufacturing process similar to the example described above. The difference between the above example and the comparative example is that each wiring member in the comparative example was not processed to have the above-mentioned predetermined shape. In other words, in a configuration employed in the comparative example, each wiring member was in contact with its corresponding edge portion of the solar cell. Here, the number of portions in which the wiring members and the edge portions were in contact with each other was 60.

### (Confirming of the Damage Caused at the Boundary Portion)

The solar cell modules according to the example and the comparative example were observed to confirm whether chipping or cracking had occurred at the edge portions of each of the solar cells.

In the solar cell module according to the example, no chipping or cracking was observed at any boundary portions of the solar cells. Such a result was attained because the example had employed the wiring members each having the predetermined shape so that each wiring member would not be in contact with corresponding edge portions of the solar cells.

On the other hand, in the solar cell module according to the comparative example, cracking was observed at 3 portions out of the 60 portions at which the wiring members and the edge portions were in contact with each other. Such a result was obtained because the wiring members were in contact with corresponding edge portions of the solar cells. Such a configuration causes excessive stress to be applied to the edge portions in the manufacturing process.

By the above results, it was confirmed that the damage, such as chipping and cracking, can be prevented from occurring at the edge portions of the solar cells by preventing the wiring members from coming in contact with the edge portions of the solar cells.

### (Other Embodiments)

Although the present invention was described by using the above embodiment, the description and the drawings, which constitute a part of this disclosure, should not be understood to limit this invention. Various alternative embodiments, examples, and operation techniques will be apparent to those skilled in the art from this disclosure.

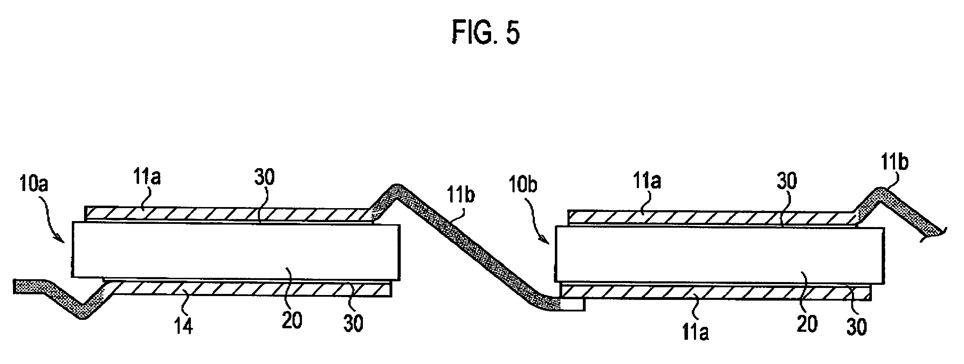

For example, in the above embodiment, the contact portion 11a and the noncontact portion 11b of the first wiring member 11 are integrally formed. However, as illustrated in Fig. 5, the contact portion 11a and the noncontact portion 11 b may be formed discretely.

Moreover, in the above embodiment, all types of the wiring members (the first wiring member 11, the second wiring member 12, and the fourth wiring member 14) provided in the solar cell module 100 are not in contact with the boundary portions α. However, as long as at least one type of the wiring member is not in contact with the boundary portions α, similar effect to the present invention can be attained.

Further, although the collecting electrode 30 is provided between the main surface of the plurality of solar cells 10 and the wiring member, the shape of the collecting electrode 30 is not limited to this. The present invention is not to limit the shape of the collecting electrode 30. In addition, the plurality of solar cells 10 does not have to include the collecting electrode 30.

Furthermore, in the above embodiment, the noncontact portions (the noncontact portions 11b, 12b, and 14b) bend before the wiring members reach each of the reference line indicating the end of the main surface of the each of the plurality of solar cells 10. Alternatively, each noncontact portion may be bent at a point outside of the end of the main surface of the plurality of solar cells 10. Additionally, the shape of the noncontact portion is not limited to the shape described in the above embodiment, and may be appropriately changed.

As described above, the present invention of course includes various embodiments and others that are not described herein. Therefore, the technical scope of the present invention is to be determined only by claimed elements according to the scope of claims as interpreted by the description and drawings.

## Claims

1. A solar cell module comprising:
a plurality of solar cells each having a first main surface, a second main surface provided on an opposite side of the first main surface, and a side surface continuous with the first main surface and the second main surface;
a first-main-surface-side protecting member provided on the first main surface side of each of the plurality of solar cells;
a second-main-surface-side protecting member provided on the second main surface side of each of the plurality of solar cells;
a sealing member which seals the plurality of solar cells between the first-main-surface-side protecting member and the second-main-surface-side protecting member; and
a wiring member electrically connected to the plurality of solar cells, wherein
the wiring member includes:
a first contact portion which contacts with the first main surface of a first solar cell included in the plurality of solar cells; and
a first noncontact portion continuous with the first contact portion and extending outward from the first main surface of the first solar cell, and
the first noncontact portion is arranged to leave a space from a boundary between the first main surface of the first solar cell and the side surface of the first solar cell.

2. The solar cell module according to claim 1, wherein
the first noncontact portion extends away from the first main surface towards the first-main-surface-side protecting member at a boundary between the first main surface and the side surface of the first solar cell.

3. The solar cell module according to claim 1, wherein
the plurality of solar cells includes a second solar cell, which is adjacent to the first solar cell,
the first solar cell and the second solar cell are connected to each other by the wiring member,
the wiring member includes:
a second contact portion continuous with the first noncontact portion and contacts with the second main surface of the second solar cell.

4. The solar cell module according to claim 1, wherein
the plurality of solar cells includes a second solar cell, which is adjacent to the first solar cell,
the first solar cell and the second solar cell are connected to each other by the wiring member,
the wiring member includes:
a second contact portion which contacts with the second main surface of the second solar cell; and
a second noncontact portion continuous with the second contact portion and extending outward from the second main surface of the second solar cell, and
the second noncontact portion is arranged to leave a space from a boundary between the first main surface of the second solar cell and the side surface of the second solar cell

5. The solar cell module according to claim 4, wherein
the second noncontact portion extends away from the second main surface towards the second-main-surface-side protecting member at a boundary between the seconed main surface and the side surface of the second solar cell.

6. The solar cell module according to claim 1, wherein
the first noncontact portion is continuous smoothly with the first contact portion.

7. The solar cell module according to claim 4, wherein
the second noncontact portion is continuous smoothly with the second contact portion.

8. The solar cell module according to claim 1, wherein
the first-main-surface-side protecting member is formed of a glass or an acrylic resin.
